# EUROPEAN PATENT APPLICATION

(11) **EP 2 566 311 A1**
(43) Date of publication of application: **06.03.2013**
(21) Application number: 11179937.5
(22) Date of filing: 02.09.2011
(51) Int. Cl.: H05K 3/42

(54) **Direct plating method**

(71) Applicant: Atotech Deutschland GmbH, 10553 Berlin (DE)
(72) Inventor: Riebel, Harald, 13629 Berlin (DE); Nichols, Richard, 12247 Berlin (DE); Jang, Don, 10587 Berlin (DE); Magaya, Tafadzwa, 80206 Denver (US)
(74) Representative: Wonnemann, Jörg

(57) **Abstract**

The present invention relates to a method for direct plating in the manufacture of printed circuit boards, IC substrates and the like. The method utilizes a conductive layer selected from electrically conductive polymers, colloidal noble metals and electrically conductive carbon particles for BMV filling and hence avoids an intermediate layer of copper deposited by electroless plating and thereby insufficient line shape and adhesion of copper tracks formed by etching in successive manufacturing steps.

## Description

### Field of the Invention

The present invention relates to a method for manufacture of printed circuit boards. More particular, the invention relates to a direct plating method in the manufacture of high density interconnect (HDI) printed circuit boards, IC substrates and the like.

### Background of the Invention

The ongoing miniaturization of features of HDI printed circuit boards, IC substrates and the like requires more advanced manufacturing methods than conventional methods such as formation of circuitry by a print and etch method.

A method known in the art is the semi-additive process (SAP) which starts from a bare dielectric substrate which is treated with a desmear process after laser drilling of blind micro vias and the like, followed by deposition of a conductive layer, selective electrolytic deposition of copper in openings of a patterned resist material and removal of the conductive layer portions which are not coated by electroplated copper. The conductive layer usually comprises a noble metal seed layer and a thin copper layer deposited by electroless plating. The main disadvantage of the SAP method is the weak adhesion between the seed layer / conductive layer and the surface of the bare dielectric substrate. The weak adhesion can lead to an undesired delamination of the copper tracks in later manufacturing steps or later use of the printed circuit board

Another method known in the art is the advanced modified semi-additive method (AM-SAP) which utilizes a substrate having a layer of copper on top of the dielectric substrate instead of a bare dielectric substrate material. Such a layer of copper on top of a dielectric substrate material is referred herein to as a copper clad. The thickness of such a copper clad ranges from 0.5 to 10 µm. The copper clad is usually manufactured by "thinning" of a thicker copper clad attached to both sides of the dielectric substrate.

Such a low thickness of copper is required because the copper clad which is not coated with electroplated copper in a later process step needs to be removed by etching afterwards. In order to obtain very fine and regular copper patterns by etching, the thickness of said copper clad must be as low as possible.

The prior art AM-SAP method comprises the steps of
(i) providing a dielectric substrate (1) having a copper clad (2) with a thickness of 0.5 to 10 µm on both sides of the dielectric substrate (1) and blind micro vias (BMVs) (3),
(ii) depositing a seed layer (5a) onto the substrate surface,
(iii) depositing a conductive layer (5) of copper onto the seed layer (5a) by electroless plating,
(iv) applying a resist layer (4) onto the copper clad (2) and patterning said resist layer (4),
(v) depositing a copper layer (6) by electroplating onto the conductive layer (5),
(vi) depositing an etch resist (7) on top of the electroplated copper (6) and removing the patterned resist layer (4),
(vii) etching away copper not protected by the etch resist (7) and removing the etch resist (7).

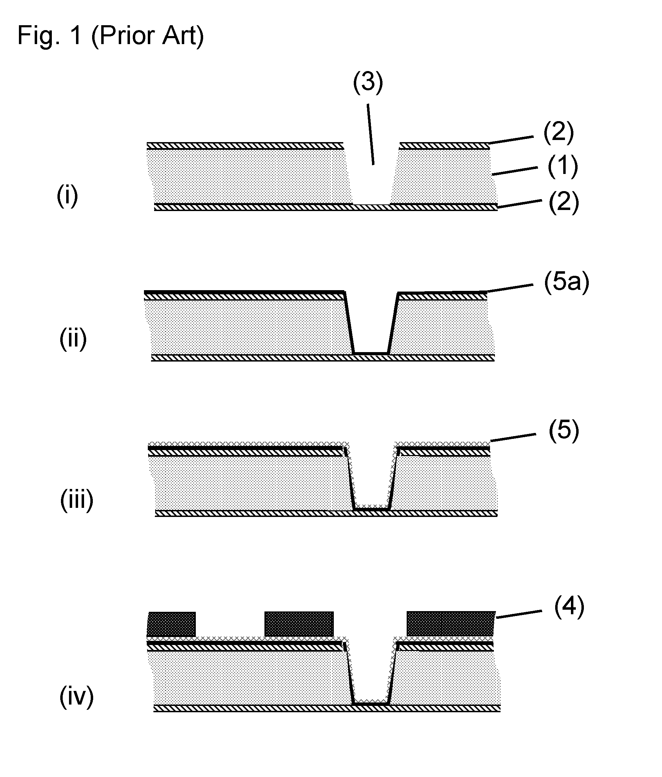

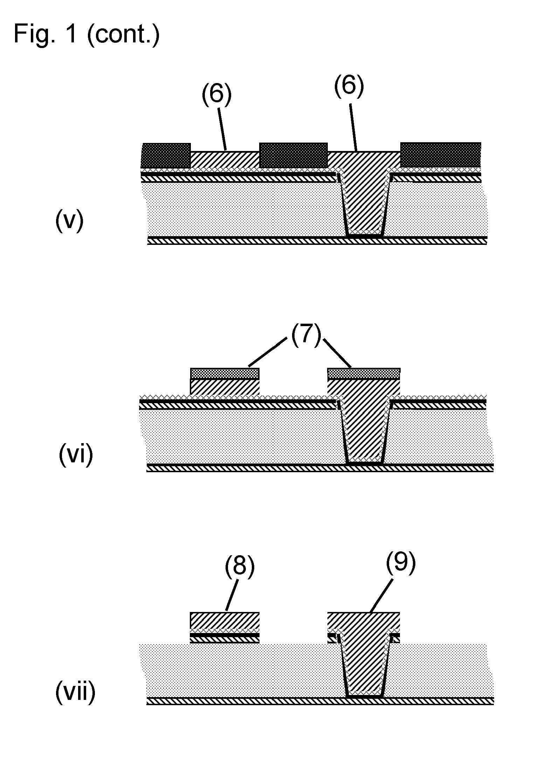

Such a process is shown in Fig. 1. The result of such a process are copper tracks (8) and copper filled BMVs (9).

The conductive layer (5) is required to provide electrical conductivity to the side walls of the BMVs which consist of dielectric substrate (1) material.

After formation of the BMVs (3) by laser drilling a cleaning operation is required to remove smear and other residues from the side walls of the BMVs. The cleaning is made by a wet chemical desmear process or by means of a plasma. Both processes are known in the art.

A seed layer (5a) is then deposited onto the copper clad (2), the dielectric side walls of the BMVs (3) and the metallic bottom of the BMVs (3). The seed layer (5a) comprises usually a noble metal, preferably palladium. Methods and materials to form such a seed layer (5a) are known in the art.

Next, the conductive layer (5) is deposited onto the seed layer (5a) by electroless plating of copper.

Both seed layer (5a) and conductive layer (5) are deposited onto the whole substrate surface. The whole substrate surface comprises the surface of the copper clad (2) and the walls of the BMVs (3).

The micro structure of copper deposited by an electroless process (conductive layer (5)) is different from that of the electroplated copper layer (6) and the copper clad (2). The different micro structure of copper deposited by different methods leads to a differing etching behaviour.

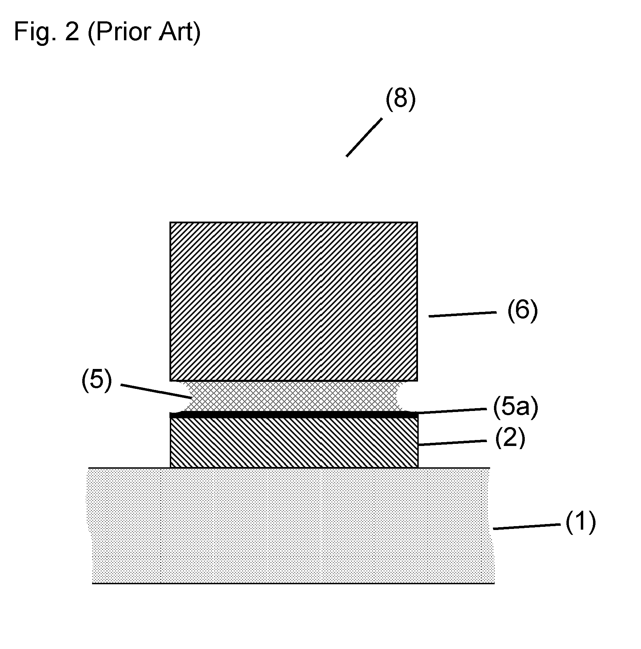

Fig. 2 shows a copper track (8) obtained from a process according to Fig. 1. The conductive layer (5) which is deposited by electroless plating of copper serves as a "demarcation line" in the copper track (8): here the etch attack is stronger than in case of the copper clad (2) and the copper layer (6) deposited by electroplating. This leads to an irregular shape of the copper track (8) which has disadvantages in terms of propagation of electrical current and furthermore reduces the adhesion of the copper layer (6) on the copper clad (2).

### Objective of the Invention

Therefore, it is the objective of the present invention to provide a process which avoids or minimizes the disadvantages derived from an intermediate layer of copper deposited by electroless plating. In particular the objectives are to increase the adhesion between a copper clad (2) and a copper layer (6) deposited by electroplating, to provide a method for manufacture of regular shaped copper tracks (8) and to avoid undercutting of copper tracks (8) during etching which is caused by an intermediate layer of copper (5) deposited by electroless plating.

### Summary of the Invention

These objectives are solved by a direct plating method comprising, in this order, the steps of
(i) providing a dielectric substrate (1) having a copper clad (2) with a thickness of 0.5 to 10 µm on both sides of the dielectric substrate (1) and at least one blind micro via (BMV) (3),
(ii) depositing a conductive layer (5) onto at least a portion of the substrate surface wherein the conductive layer (5) is selected from the group consisting of electrically conductive polymers, colloidal particles comprising a noble metal and electrically conductive carbon particles,
(iii) applying a resist layer (4) onto the copper clad (2) and patterning said resist layer (4) and
(iv) depositing a copper layer (6) by electroplating onto the conductive layer (5).

### Brief Description of the Figures

Figure 1 shows a prior art method for obtaining a copper track (8) and a BMV (9).
Figure 2 shows a schematic cross-section of a copper track (8) obtained by the prior art method according to Fig. 1.

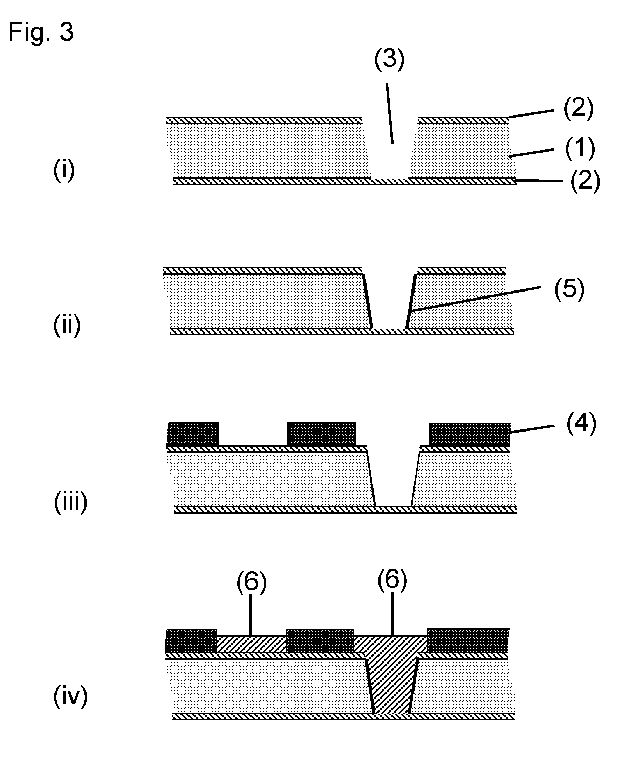

Figure 3 shows a method according to the present invention for obtaining a copper track (8) and a BMV (9).
Figure 4 shows a schematic cross-section of a copper track (8) obtained by a method according to Fig. 3.
Figure 5 shows another method according to the present invention for obtaining a copper track (8) and a BMV (9).
Figure 6 shows a schematic cross-section of a copper track (8) obtained by a method according to Fig. 5.

### Detailed Description of the Invention

The dielectric substrate (1) is made of a polymeric material such as epoxy resins, cyanate ester resins, bismaleimide resins, bismaleide triazine resins, benzoxazine resins, and mixtures thereof. The dielectric substrate (1) can further contain a reinforcement such as a glass reinforcement. The dielectric substrate (1) comprises a copper clad (2) on both sides. The thickness of the copper clad (2) ranges from 0.5 to 10 µm, more preferably from 1 to 5 µm and most preferably from 1.5 to 3.5 µm. The copper clad (2) can for example be obtained by "thinning" of a thick copper clad Thinning is usually made by a differential etch process. Optionally, a copper clad (2) is directly manufactured without thinning.

BMVs (3) are formed by laser drilling through the copper clad (2) and the material of the dielectric substrate (1) down to the copper clad (2) of the other side of the dielectric substrate (1) which serves as the metallic bottom of the BMVs (3). Optionally, a laser radiation absorption layer is deposited onto the surface of the copper clad (2) prior to laser drilling.

Next, the side walls of the BMVs (3) are subjected to a cleaning process in order to remove smear and other residues derived from laser drilling. The cleaning process can be either a wet chemical desmear or a plasma desmear process. Such methods are known in the art (e.g.: C. F. Coombs, Jr., "Printed Circuits Handbook", 5th Ed. 2001, Chapter 28.4, pages 28.5 to 28.7).

A wet chemical desmear process comprises the steps of a) swelling the surfaces of the dielectric substrate (1), etching the surfaces of the dielectric substrate (1) with a permanganate solution and c) removing MnO₂ from the surfaces of the dielectric substrate (1) by reducing.

After desmearing the side walls of the BMVs (3) a conductive layer (5) formed by the group consisting of electrically conductive polymers, colloidal noble metal particles and electrically conductive carbon particles is deposited onto the substrate surface. The substrate surface comprises the copper clad (2), the side walls of the BMVs (3) formed before by drilling and the backside of the copper clad (2) on the backside of the substrate which serves as a metallic bottom of the BMVs (3).

In case of an electrically conductive polymer the conductive layer (5) is deposited onto those portions of the substrate surface which comprise the side walls of the BMVs formed before. Said side walls of the BMVs consist of nonconducting dielectric material.

Preferably, the conductive layer (5) comprises an electrically conductive polymer selected form the group consisting of polythiophene, polypyrrol, polyaniline, derivatives and mixtures thereof.

The most preferred electrically conductive polymer is selected from polythiophene, derivatives thereof and mixtures thereof.

The conductive layer (5) comprising polythiophene, a derivative thereof and a mixture thereof can be formed in a process comprising, in this order, the steps of
a) bringing the surfaces of the dielectric substrate (1) into contact with a solution of a water-soluble polymer,
b) treating the surfaces of the dielectric substrate (1) with a permanganate solution and
c) treating the surfaces of the dielectric substrate (1) with an acidic aqueous solution or an acidic microemulsion of aqueous base containing at least one thiophene compound and at least one alkane sulfonic acid.

Such a process only leads to the formation of a conductive organic polymer on those parts of the substrate surface which consist of the dielectric substrate material (1), i.e. the side walls of the BMVs (3). No electrically conductive polymer is formed on the surface of the copper clad (2).

The water-soluble polymer used in step a) is selected from the group consisting of polyvinyl amine, polyethylene imine, polyvinyl imidazole, alkylamine ethylene oxide copolymers, polyethylene glycol, polypropylene glycol, copolymers of ethylene glycol and polypropylene glycol, polyvinyl alcohol, polyacrylates, polyacrylamide, polyvinylpyrrolidone and mixtures thereof. The concentration of the water-soluble polymer ranges from 20 mg/l to 10 g/l.

The solution of a water-soluble polymer may further contain a water-soluble organic solvent selected from the group consisting of ethanol, propanol, ethylene glycol, diethyleneglycol, glycerine, dioxin, butyrolacton, N-methyl pyrrolidone, dimethyl formamide, dimethylacetamide, half ethers and half esters of ethylene glycol. The water-soluble organic solvent may be utilized either in pure form or diluted with water. The concentration of the water-soluble organic solvent ranges from 10 ml/l to 200 ml/l. The solution of a water-soluble polymer is held at a temperature in the range of 25°C to 85 °C and the dielectric substrate (1) is immersed in this solution for 15 s to 15 min during step a).

Next, the surfaces of the dielectric substrate (1) are treated with a permanganate solution in step b). The source of permanganate ions can be any water-soluble permanganate compound. Preferably the source of permanganate ions is selected from sodium permanganate and potassium permanganate. The concentration of permanganate ions ranges from 0.1 mol/l to 1.5 mol/l. The permanganate solution can be either acidic or alkaline. Preferably, the permanganate solution has a pH value in the range of 2.5 to 7. By means of step b) a layer of MnO₂ is formed on the side walls of a BMV (3).

The surfaces of the dielectric substrate (1) are then contacted in step c) with a solution comprising a thiophene compound and an alkane sulfonic acid.

The thiophene compound is preferably selected from 3-heterosubstituted thiophenes and 3,4-heterosubstituted thiophenes. Most preferably, the thiophene compound is selected from the group consisting of 3,4-ethylene dioxythiophene, 3-methoxy thiophene, 3-methyl-4-methoxy thiophene and derivatives thereof. The concentration of the thiophene compound ranges from 0.001 mol/l to 1 mol/l, more preferably from 0.005 mol/l to 0.05 mol/l.

The alkane sulfonic acid is selected from the group comprising methane sulfonic acid, ethane sulfonic acid, methane disulfonic acid, ethane disulfonic acid and mixtures thereof. The concentration of the alkane sulfonic acid is set by adjusting the desired pH value of the solution utilized in step c). Preferably the pH value of said solution is set in the range of 0 to 3, more preferably in the range of 1.5 to 2.1.

When contacting the surfaces of a dielectric substrate (1) with said acidic aqueous solution or an acidic microemulsion of aqueous base containing at least one thiophene compound and at least one alkane sulfonic acid in step c) the thiophene compound polymerizes when in contact with MnO₂ deposited in step b). The conductive layer (5) is then formed by polythiophene and derivatives thereof obtained by the thiophene compounds.

Such a process only leads to the formation of a conductive organic polymer on those parts of the substrate surface which consist of the dielectric substrate material (1), i.e. the side walls of the BMVs (3). The surface of the copper clad (2) is free of said conductive organic polymer serving as the conductive layer (5).

Processes involving the use of electrically conductive carbon particles have been developed by the company "Electrochemicals" and are marketed, for example, under the trade name "Shadow". Another process is known in the art as the "black hole" process which has been developed by the company MacDermid. Suitable electrically conductive carbon particles are for example graphite and derivatives thereof (Printed Circuits Handbook, 5th Ed. 2001, Ed.: C. F. Coombs, Jr., pp. 30.4 to 30.6). The substrate surface is first conditioned and then coated with electrically conductive carbon particles. Next, the carbon coating is dried and the portions of carbon particles deposited onto the copper clad (2) are removed. Such a carbon coating serves as a conductive layer (5) and is suitable as a surface for electroplating of copper.

In another embodiment of the present invention the conductive layer (5) is formed by a colloidal noble metal (Printed Circuits Handbook, 5th Ed. 2001, Ed.: C. F. Coombs, Jr., pp. 30.2 to 30.4). Processes involving the use of colloidal palladium particles have been developed by the companies Shipley Ronal and Atotech and are known, for example, under the trade names "Crimson", "Conductron" and "Neopact", respectively. The conductivity of colloidal palladium particles can be increased by e.g. providing sulfide "bridges" between individual colloidal palladium particles adsorbed to the substrate surface. The conductivity of the adsorbed colloidal palladium particles is then high enough to serve as a conductive layer (5) for successive electroplating of copper.

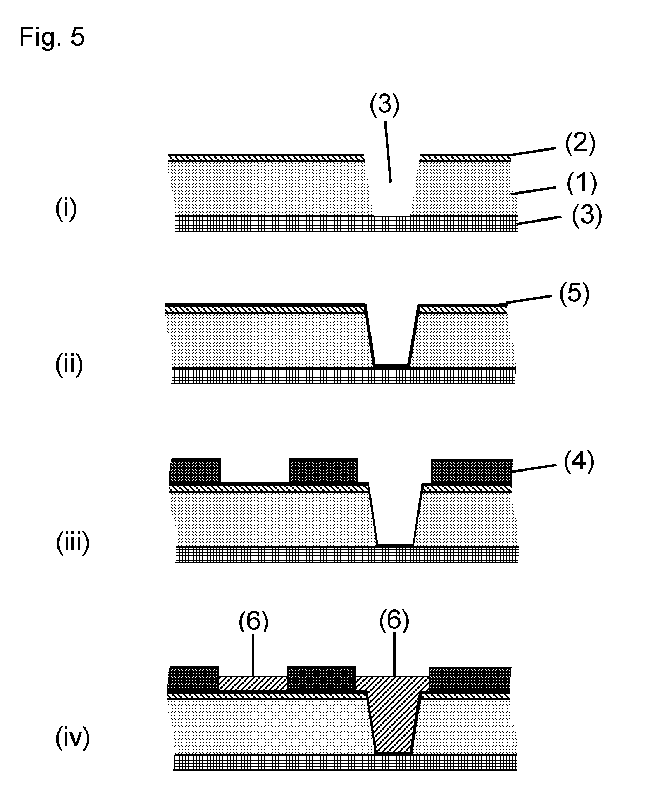

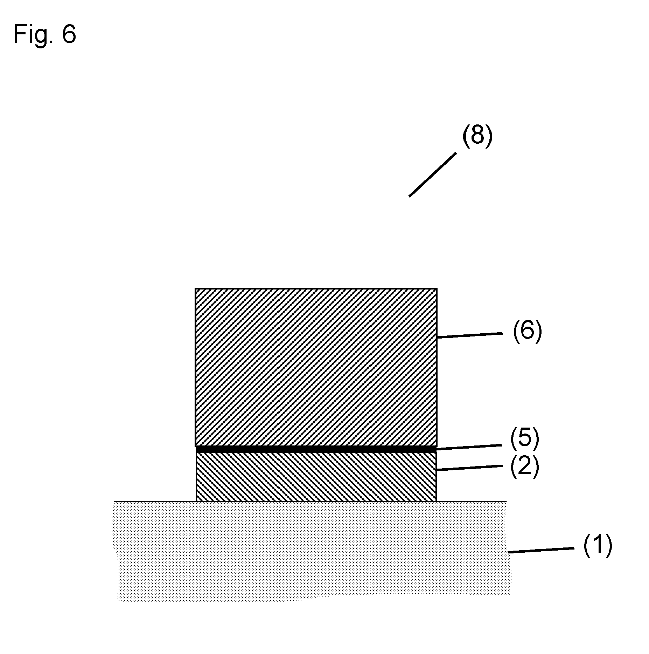

The embodiments using either electrically conductive carbon particles or colloidal noble metal particles as conductive layer (5) are shown in Fig. 5. A resulting copper track (8) is shown in Fig. 6.

Next, the surfaces of the dielectric substrate (1) are rinsed and then suited for formation of copper tracks (8) and copper filled BMVs (9) by electroplating of copper.

Electroplating solutions for copper deposition suitable to be used in step (iv) are known in the art. Preferably acidic copper plating baths comprising copper ions, an acid, organic additives and chloride ions are used. Such copper plating bath compositions are disclosed for example in C. F. Coombs, Jr., "Printed Circuits Handbook", 5th Ed. 2001, Chapter 29.4, pages 29.4 to 29.15.

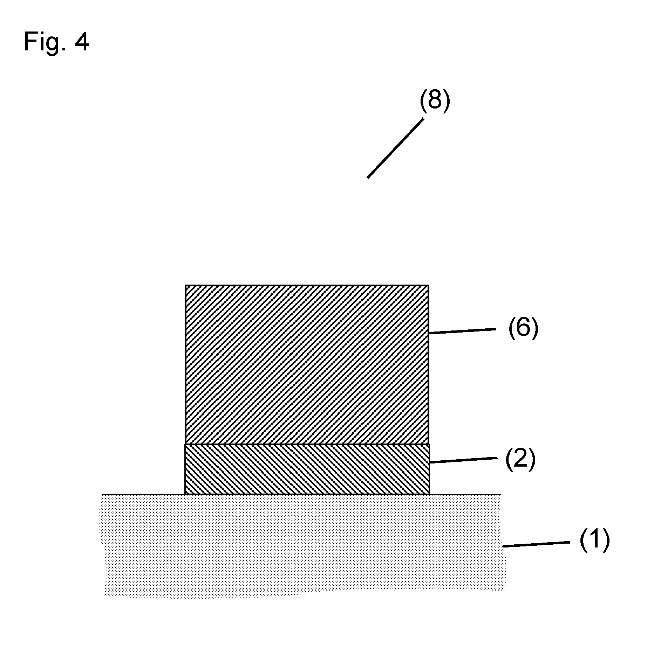

The advantages of a method according to the present invention in respect to AM-SAP methods known in the art are manifold: due to the lack of a conductive layer (5) comprising a copper layer deposited by electroless plating, the adhesion between a copper layer (6) deposited by electroplating onto a copper clad (2) is increased. Furthermore, the shape of a copper track (8) after etching is more regular (Fig. 4 and 6) compared to a copper track (8) obtained from AM-SAP methods known in the art which comprise a layer of copper deposited by electroless plating between the copper clad (2) and the electroplated copper layer (6) (Fig. 2).

The following non-limiting examples further illustrate the present invention.

### Examples

### Example 1 (comparative)

A dielectric substrate (1) having a copper clad (2) with a thickness of 2 µm attached to both sides and BMVs (3) having a diameter of 60 to 130 µm and a aspect ratio of at maximum 1:1 is first immersed in a cleaner comprising H₂SO₄ (Securiganth^{®} Etch Cleaner SPS, a product of Atotech Deutschland GmbH) at 30°C for 30 s. Next, a seed layer (5a) comprising palladium is deposited. A thin layer of copper serving as the conductive layer (5) is deposited by electroless plating (Printoganth^{®} U Plus, a product of Atotech Deutschland GmbH, T = 35°C, t = 360 s). A copper layer (6) is deposited by electroplating (Cupracid^{®} HL, a product of Atotech Deutschland GmbH) onto the conductive layer (5).

After application of a tin etch resist, removal of the resist layer (4) and those portions of the conductive layer (5) and the thin copper clad (2) which are not coated by a copper layer (6) deposited by electroplating are etched away. A cross-section of the dielectric substrate is prepared and investigated with an optical microscope.

Accordingly, copper tracks show an undesired undercutting of the conductive layer (5) consisting of electroless plated copper (Fig. 2).

### Example 2

A dielectric substrate (1) having a copper clad (2) with a thickness of 2 µm attached to both sides and BMVs (3) having a diameter of 60 to 130 µm and a aspect ratio of at maximum 1:1 is first immersed in a cleaner comprising H₂SO₄ (Securiganth^{®} Etch Cleaner SPS, a product of Atotech Deutschland GmbH) at 30°C for 30 s. Next, a conductive layer (5) is deposited by a) immersing the surfaces of the dielectric substrate (1) in a solution comprising a water-soluble polymer (Seleo^{®} CP Conditioner Plus, a product of Atotech Deutschland GmbH, T = 30°C, t = 30 s), b) immersing the surfaces of the dielectric substrate (1) in a solution comprising permanganate ions (Securiganth^{®} P 500, a product of Atotech Deutschland GmbH, T = 90°C, t = 70 s) and c) immersing the surfaces of the dielectric substrate (1) in a solution comprising a thiophene compound and an alkane sulfonic acid (Seleo^{®} CP Plus, a product of Atotech Deutschland GmbH) at T = 20°C for t = 90 s.

A copper layer (6) is deposited by electroplating (Cupracid^{®} HL, a product of Atotech Deutschland GmbH) onto the conductive layer (5) and those portions of the copper clad (2) which are not covered by the patterned resist layer (4).

After application of a tin etch resist, removal of the resist layer (4) and etching away those portions of the conductive layer (5) and the copper clad (2) which are not covered by a copper layer (6) deposited by electroplating, a cross-section of the dielectric substrate was prepared and investigated with an optical microscope.

Accordingly, copper tracks (8) show the desired regular shape (Fig. 4).

## Claims

1. A direct plating method comprising, in this order, the steps of
(i) providing a dielectric substrate (1) having a copper clad (2) with a thickness of 0.5 to 10 µm on both sides of the dielectric substrate (1) and at least one blind micro via (BMV) (3),
(ii) depositing a conductive layer (5) onto at least a portion of the substrate surface wherein the conductive layer (5) is selected from the group consisting of electrically conductive polymers, colloidal particles comprising a noble metal and electrically conductive carbon particles,
(iii) applying a resist layer (4) onto the copper clad (2) and patterning said resist layer (4) and
(iv) depositing a copper layer (6) by electroplating onto the conductive layer (5).

2. The direct plating method according to claim 1 wherein the portion of the substrate surface comprises the side walls of the at least one blind micro via.

3. The direct plating method according to any of the foregoing claims wherein the conductive layer (5) comprises an electrically conductive polymer which is selected from the group consisting of polythiophene, polypyrrole, polyaniline, derivatives and mixtures thereof.

4. The direct plating method according to any of the foregoing claims wherein the conductive layer (5) in step (ii) is formed by
(ii) a) bringing the surfaces of the dielectric substrate (1) into contact with a solution of a water-soluble polymer,
(ii) b) treating the surfaces of the dielectric substrate (1) with a permanganate solution and
(ii) c) treating the surfaces of the dielectric substrate (1) with an acidic aqueous solution or an acidic microemulsion of aqueous base containing at least one thiophene compound and at least one alkane sulfonic acid.

5. The direct plating method according to claim 4 wherein the water-soluble polymer is selected from the group consisting of polyvinyl amine, polyethylene imine, polyvinyl imidazole, alkylamine ethylene oxide copolymers, polyethylene glycol, polypropylene glycol, copolymers of ethylene glycol and polypropylene glycol, polyvinyl alcohol, polyacrylates, polyacrylamide, polyvinylpyrrolidone and mixtures thereof.

6. The direct plating method according to claims 4 and 5 wherein the concentration of the water-soluble polymer ranges from 20 mg/l to 10 g/l.

7. The direct plating method according to any of claims 4 to 6 wherein the concentration of permanganate ions ranges from 0.1 mol/l to 1.5 mol/l.

8. The direct plating method according to any of claims 4 to 7 wherein the at least one thiophene compound is selected from the group consisting of 3-heterosubstituted thiophenes and 3,4-heterosubstituted thiophenes.

9. The direct plating method according to any of claims 4 to 8 wherein the concentration of the at least one thiophene compound ranges from 0.001 mol/l to 1 mol/l.

10. The direct plating method according to any of claims 4 to 9 wherein the at least one alkane sulfonic acid is selected from the group comprising methane sulfonic acid, ethane sulfonic acid, methane disulfonic acid, ethane dilsulfonic acid and mixtures thereof.

11. The direct plating method according to any of claims 4 to 10 wherein the pH value of the solution comprising at least one thiophene compound and at least on alkane sulfonic acid ranges from 0 to 3.

12. The direct plating method according to claim 1 wherein the colloidal noble metal particles are colloidal palladium particles.

13. The direct plating method according to claim 1 wherein the electrically conductive carbon particles comprise graphite or a derivative thereof.

14. The direct plating method according to any of the foregoing claims wherein the thickness of the copper clad (2) ranges from 1 to 5 µm.

15. The direct plating method according to any of the foregoing claims wherein the thickness of the copper clad (2) ranges from 2 to 3 µm.
